# EUROPEAN PATENT APPLICATION

(11) **EP 1 791 207 A1**
(43) Date of publication of application: **30.05.2007**
(21) Application number: 06019546.8
(22) Date of filing: 19.09.2006
(51) Int. Cl.: H01M 8/04, H02J 7/34, H02J 3/38, H02M 7/48

(54) **power converting apparatus for fuel cell and method thereof**

(30) Priority: 30.09.2005 KR 20050092608
(71) Applicant: LG Electronics Inc., Yongdungpo-gu Seoul (KR); LG Chem, Ltd., Yongdungpo-Gu Seoul (KR)
(72) Inventor: Choi, Hong, Manan-Gu, Anyang, Gyeonggi-Do (KR); Kim Tae-Won, Anyang, Gyeonggi-Do (KR)
(74) Representative: Urner, Peter

(57) **Abstract**

A power converting apparatus for a fuel cell, and a method thereof. The power converting apparatus for a fuel cell comprises: a converting unit for converting a DC voltage outputted from a stack of a fuel cell into a boosted or dropped AC voltage by being switched by a switching control signal; and a controlling unit for comparing the detected AC voltage level with a preset AC voltage level, and outputting a switching control signal for controlling a switching of the converting unit on the basis of the comparison result.

## Description

### BACKGROUND OF THE INVENTION

### 1. Field of the Invention

The present invention relates to a fuel cell, and more particularly, to a power converting apparatus for a fuel cell capable of maximizing a power conversion efficiency of a fuel cell and a method thereof.

### 2. Description of the Background Art

Generally, a fuel cell system serves to directly convert fuel energy into electric energy.

The fuel cell system is provided with an anode and a cathode at both sides of a high molecule electrolyte membrane. As a fuel of hydrogen is electrochemically oxidized at the anode and oxygen is electrochemically deoxidized at the cathode, electrons are generated. The fuel cell system generates electric energy as the generated electrons move.

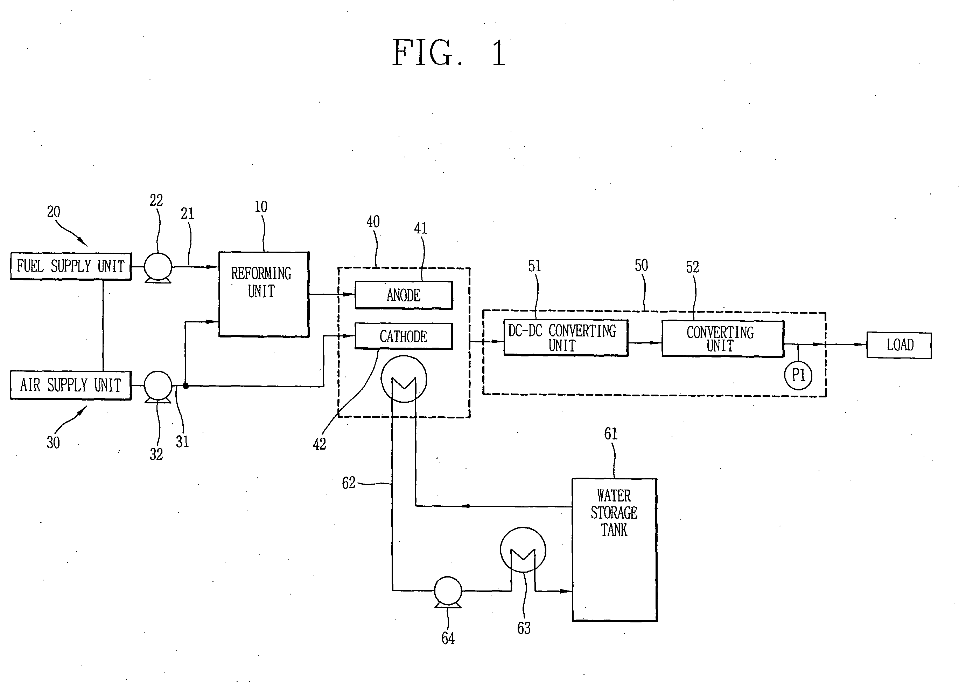

FIG. 1 is a diagram showing a proton exchange membrane fuel cell (PEMFC), in which a hydrocarbon-based fuel such as LNG, LPG, CH₃OH, etc. (LNG in drawing) undergoes a desulfurization process, a reforming process, and a hydrogen refining process in a reformer, so that only hydrogen is refined thus to be used as a fuel.

As shown in FIG. 1, the conventional fuel cell system comprises a reforming unit 10 for refining hydrogen from LNG; a fuel supply unit 20 for supplying a refined hydrogen to an anode by connecting the reforming unit 10 to the anode; an air supply unit 30 for supplying atmospheric air to a cathode; a stack unit 40 having an anode 41 to which hydrogen is supplied and a cathode 42 to which air is supplied, for generating electric power and heat by electrochemically reacting hydrogen and air; a power output unit 50 connected to an outlet of the stack unit 40 for supplying power to a load; a heat exchange unit 60 for cooling the reforming unit 10 and the stack unit 40 by respectively supplying water thereto; and a controller (not shown) electrically connected to each of the units and controlling an operation of each unit.

The power output unit 50 comprises a DC-DC converting unit 51 for generating an alternating current (AC) by switching a direct current (DC) generated from the stack unit 40, and rectifying the generated AC into a DC; and a converting unit 52 for converting a DC outputted from the DC-DC converting unit 51 into an AC thereby generating an AC.

An unexplained reference numeral 21 denotes a fuel supply line, 22 denotes a fuel supply pump, 31 denotes an air supply line, 61 denotes a water storage tank, 62 denotes a water circulation line, 63 denotes a heat emitter, and 64 denotes a water circulation pump.

An operation of the conventional fuel cell system will be explained.

First, a hydrocarbon-based fuel is refined in the reforming unit 10, thereby refining hydrogen. The refined hydrogen is supplied to the anode 41 of the stack unit 40.

The reforming unit 10 supplies air to the cathode 42 of the stack unit 40.

An electrochemical oxidation is performed in the anode 41 of the stack unit and an electrochemical deoxidation is performed in the cathode 42 of the stack unit 40.

While the oxidation and the deoxidation are performed, electrons are generated. As the generated electrons move to the cathode 42 from the anode 41, a DC voltage is generated. The generated DC voltage is converted into an AC voltage by the DC-DC converting unit 51 of the power output unit 50.

An AC voltage outputted form the DC-DC converting unit 51 is boosted or dropped by a control signal outputted from the controlling unit (not shown). Then, the boosted or dropped AC voltage is rectified to a DC voltage thus to be applied to the converting unit 52.

The converting unit 52 converts a DC voltage outputted from the DC-DC converting unit 51 into an AC voltage, and supplies the AC voltage to a load such as a home electric unit.

However, the conventional has the following problems. First, when a voltage outputted from the fuel cell is to be converted into a commercial voltage, the voltage outputted from the fuel cell is boosted or dropped by the DC-DC converting unit, and then the boosted or dropped voltage has to be converted into an AC voltage. As the voltage outputted from the fuel cell is converted into a commercial voltage by two steps, a power conversion efficiency is lowered.

Furthermore, the number of components of a semiconductor device for a power conversion is increased, and thus a production cost is increased.

### BRIEF DESCRIPTION OF THE INVENTION

Therefore, an object of the present invention is to provide a power converting apparatus for a fuel cell capable of enhancing a power conversion efficiency by matching an impedance between a fuel cell and a power line by an impedance matching unit, and by converting a DC voltage outputted from the fuel cell to an AC voltage by boosting or dropping by a converting unit, and a method thereof.

To achieve these and other advantages and in accordance with the purpose of the present invention, as embodied and broadly described herein, there is provided a power converting apparatus for a fuel cell, comprising: a converting unit for converting a DC voltage outputted from a fuel cell into a boosted or dropped AC voltage by being switched by a switching control signal; and a controlling unit for comparing the detected AC voltage with a preset AC voltage, and outputting a switching control signal for controlling a switching of the converting unit on the basis of the comparison result.

To achieve these and other advantages and in accordance with the purpose of the present invention, as embodied and broadly described herein, there is provided a power converting apparatus for a fuel cell that comprises a stack unit having an anode and a cathode and generating electric power by electrochemically reacting hydrogen and air, the apparatus comprising: an impedance matching unit for matching an impedance of a power line of the fuel cell to an impedance of a substantial commercial power line; a converting unit for converting a DC voltage inputted from the impedance matching unit into a boosted or dropped AC voltage by being switched by a switching control signal; a filter for filtering an AC voltage outputted from the converting unit and thereby outputting an AC voltage of a sine wave; a power detecting unit for detecting an AC voltage outputted from the filter; and a controlling unit for comparing the detected AC voltage with a preset AC voltage, and controlling a conversion of the DC voltage outputted from the fuel cell into an AC voltage on the basis of the comparison result.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a block diagram showing an example of a fuel cell system in accordance with the conventional art;
FIG. 2 is a schematic view showing a construction of a power converting apparatus for a fuel cell according to the present invention;
FIG. 3 is a flowchart showing a method for converting a power of a fuel cell according to the present invention;
FIG. 4 is a view showing a switching waveform of a converting unit according to the present invention; and
FIG. 5 is a view showing a waveform of an output voltage from the converting unit according to the present invention.

### DETAILED DESCRIPTION OF THE INVENTION

Reference will now be made in detail to the preferred embodiments of the present invention, examples of which are illustrated in the accompanying drawings.

Hereinafter, a power converting apparatus for a fuel cell capable of enhancing a power conversion efficiency by converting a DC voltage outputted from a fuel cell to an AC voltage by boosting or dropping by a converting unit without an additional boosting device or a dropping device, and a method thereof will be explained in more detail with reference to the attached drawings.

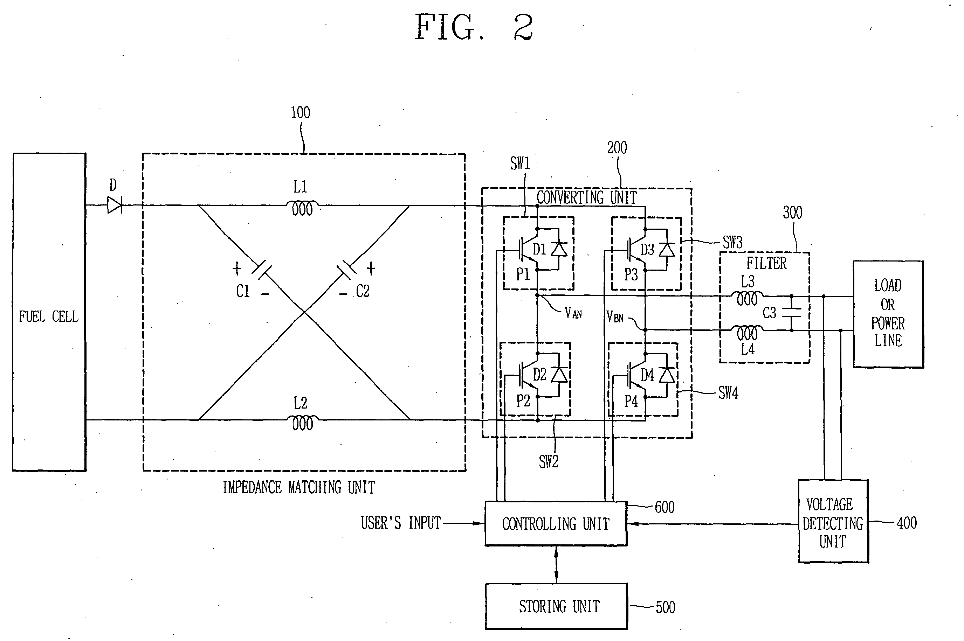

FIG. 2 is a schematic view showing a construction of a power converting apparatus for a fuel cell according to the present invention.

As shown in FIG. 2, the power converting apparatus for a fuel cell according to the present invention comprises an impedance matching unit 100, a converting unit 200, a filter 300, a voltage detecting unit 400, a storing unit 500, and a controlling unit 600.

The impedance matching unit 100 matches an impedance of a power line of the fuel cell to an impedance of a substantial commercial power line.

The impedance matching unit 100 comprises a first coil L1 having a front end connected to an output port of the fuel cell, a first capacitor C1 having a front end connected to the output port of the fuel cell, a second coil L2 having a front end connected to a rear end of the first coil L1 and a rear end connected to a rear end of the first capacitor C1, and a second capacitor C2 connected between the rear end of the first coil L1 and the front end of the second coil L2.

The converting unit 200 converts a DC voltage of the fuel cell inputted from the impedance matching unit 100 into an AC voltage by boosting or dropping, and then outputs the boosted or dropped AC voltage.

The converting unit 200 comprises a second PNP transistor P2 having a collector connected to an emitter of a first PNP transistor P1, a third PNP transistor P3 having a collector connected to a collector of the first PNP transistor P1, and a fourth PNP transistor P4 having a collector connected to an emitter of the third PNP transistor P3 and having an emitter connected to an emitter of the second PNP transistor P2. The converting unit 200 outputs a difference value between a voltage (VAN) generated at a connection point between the first PNP transistor P1 and the second PNP transistor P2 and a voltage (VBN) generated at a connection point between the third PNP transistor P3 and the fourth PNP transistor P4.

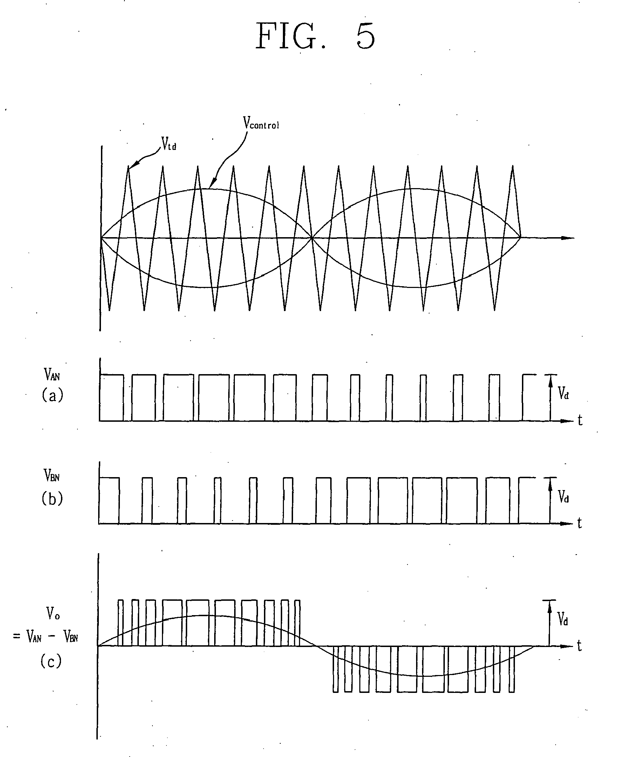

More concretely, as shown in FIG. 5(a), the converting unit 200 outputs a voltage (VAN) generated at a connection point between the first PNP transistor P1 and the second PNP transistor P2. As shown in FIG. 5(b), the converting unit 200 outputs a voltage (VBN) generated at a connection point between the third PNP transistor P3 and the fourth PNP transistor P4. As shown in FIG. 5(c), the converting unit 200 outputs a final voltage (VO).

A diode is respectively connected to the first to fourth PNP transistors P1 to P4 in parallel in order to prevent an inverse current.

The filter 300 that is an AC filter filters an AC voltage outputted from the converting unit 200, thereby generating an AC voltage of a sine wave.

The filter 300 comprises a capacitor C3 for discharging a charged voltage when the converting unit 200 performs a voltage dropping operation.

The voltage detecting unit 400 detects a level of an AC voltage outputted from the filter 300.

The storing unit 500 stores each RMS value corresponding to a plurality of AC voltage levels.

The controlling unit 600 compares an AC voltage level detected by the voltage detecting unit 400 with a preset AC voltage level, controls a conversion mode of the converting unit 200 on the basis of the comparison result, and outputs a switching control signal for controlling a switching of the converting unit 200.

More concretely, the controlling unit 600 compares an AC voltage detected by the voltage detecting unit 400 with an AC voltage preset by a user. As a result of the comparison, if the AC voltage detected by the voltage detecting unit 400 is larger than the preset AC voltage, the controlling unit 600 drops an AC voltage outputted from the converting unit 200. On the contrary, if the AC voltage detected by the voltage detecting unit 400 is smaller than the preset AC voltage, the controlling unit 600 boosts an AC voltage outputted from the converting unit 200.

At the time of a voltage dropping mode, the controlling unit 600 converts an AC voltage level detected by the voltage detecting unit 400 into an RMS value. If the converted RMS value is larger than an RMS value corresponding to the preset AC voltage, the controlling unit 600 increases dead time of a switching control signal for simultaneously turning off the first PNP transistor P1, the second PNP transistor P2, the third PNP transistor P3, and the fourth PNP transistor P4. On the contrary, if the converted RMS value is smaller than the RMS value corresponding to the preset AC voltage, the controlling unit 600 decreases dead time of a switching control signal for simultaneously turning off the first PNP transistor P1, the second PNP transistor P2, the third PNP transistor P3, and the fourth PNP transistor P4.

At the time of a voltage boosting mode, the controlling unit 600 converts an AC voltage level detected by the voltage detecting unit 400 into an RMS value. If the converted RMS value is larger than an RMS value corresponding to the preset AC voltage, the controlling unit 600 increases overlap time of a switching control signal for simultaneously turning on the first PNP transistor P1, the second PNP transistor P2, the third PNP transistor P3, and the fourth PNP transistor P4. On the contrary, if the converted RMS value is smaller than the RMS value corresponding to the preset AC voltage, the controlling unit 600 decreases overlap time of a switching control signal for simultaneously turning on the first PNP transistor P1, the second PNP transistor P2, the third PNP transistor P3, and the fourth PNP transistor P4.

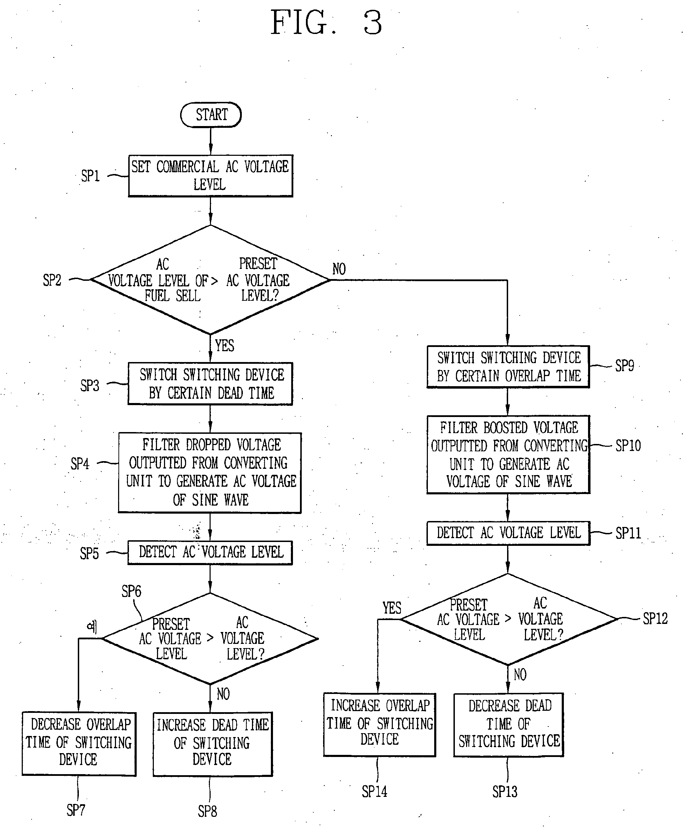

An operation of the power converting apparatus for a fuel cell according to the present invention will be explained with reference to FIG. 3.

First, a user sets a level of a commercial AC voltage to be used at a load by an inputting unit (not shown) (SP1).

Then, the controlling unit 600 compares the AC voltage level detected by the voltage detecting unit 400 with the commercial AC voltage level set by a user (SP2), and controls a switching mode of the converting unit 200 on the basis of the comparison result.

More concretely, when the AC voltage level detected by the voltage detecting unit 400 is larger than the AC voltage level set by a user, the controlling unit 600 drops an AC voltage outputted from the converting unit 200.

On the contrary, when the AC voltage level detected by the voltage detecting unit 400 is smaller than the AC voltage level set by a user, the controlling unit 600 boosts an AC voltage outputted from the converting unit 200.

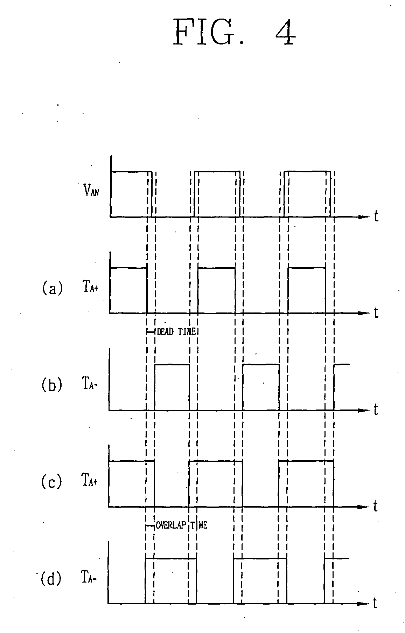

A voltage boosting operation and a voltage dropping operation by the converting unit 200 will be explained with reference to FIG. 4.

As shown in FIGS. 4(a) and 4(b), at the time of a voltage dropping mode, the controlling unit 600 controls a switching control signal for simultaneously turning off the first PNP transistor P1, the second PNP transistor P2, the third PNP transistor P3, and the fourth PNP transistor P4 of the converting unit 200 to have dead time. Under the state, the converting unit 200 drops a DC voltage outputted from the fuel cell by a certain level, and outputs the dropped DC voltage (SP3).

Then, the filter 300 filters the dropped AC voltage outputted from the converting unit 200 and thereby outputs an AC voltage of a sine wave to a corresponding load (SP4).

The voltage detecting unit 400 detects a level of the AC voltage outputted from the converting unit 200 thus to apply it to the controlling unit 600 (SP5).

Then, the controlling unit 600 converts an AC voltage level detected by the voltage detecting unit 400 into an RMS value. If the converted RMS value is larger than an RMS value corresponding to a preset AC voltage (SP6), the controlling unit 600 increases dead time of a switching control signal for simultaneously turning off the first PNP transistor P1, the second PNP transistor P2, the third PNP transistor P3, and the fourth PNP transistor P4 (SP8).

On the contrary, if the converted RMS value is smaller than the RMS value corresponding to the preset AC voltage (SP6), the controlling unit 600 decreases dead time of a switching control signal for simultaneously turning off the first PNP transistor P1, the second PNP transistor P2, the third PNP transistor P3, and the fourth PNP transistor P4 of the converting unit 200 (SP7).

As shown in FIGS. 4(c) and 4(d), at the time of a voltage boosting mode, the controlling unit 600 controls a switching control signal for simultaneously turning on the first PNP transistor P1, the second PNP transistor P2, the third PNP transistor P3, and the fourth PNP transistor P4 of the converting unit 200 for a certain time to have overlap time. Under the state, the converting unit 200 boosts a DC voltage outputted from the fuel cell by a certain level thereby to output it (SP9).

Then, the filter 300 filters the boosted AC voltage outputted from the converting unit 200 into an AC voltage having a since wave, and thus supplies it to a corresponding load (SP10).

The voltage detecting unit 400 detects an AC voltage outputted from the converting unit 200, and then applies it to the controlling unit 600 (SP11).

The controlling unit 600 converts an AC voltage level detected by the voltage detecting unit 400 into an RMS value. If the converted RMS value is larger than an RMS value corresponding to a preset AC voltage (SP12), the controlling unit 600 increases overlap time of a switching control signal for simultaneously turning on the first PNP transistor P1, the second PNP transistor P2, the third PNP transistor P3, and the fourth PNP transistor P4 of the converting unit 200 (SP14).

On the contrary, if the converted RMS value is smaller than the RMS value corresponding to the preset AC voltage (SP12), the controlling unit 600 decreases overlap time of a switching control signal for simultaneously turning on the first PNP transistor P1, the second PNP transistor P2, the third PNP transistor P3, and the fourth PNP transistor P4 of the converting unit 200 (SP13).

As aforementioned, in the power converting apparatus for a fuel cell and the method thereof according to the present invention, a power conversion efficiency of a fuel cell is enhanced by converting a DC voltage outputted from the fuel cell to an AC voltage by boosting or dropping by the converting unit without an additional boosting device or a dropping device.

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalents of such metes and bounds are therefore intended to be embraced by the appended claims.

## Claims

1. A power converting apparatus for a fuel cell, comprising:
a converting unit for converting a DC voltage outputted from a fuel cell into a boosted or dropped AC voltage by being switched by a switching control signal; and
a controlling unit for comparing the detected AC voltage with a preset AC voltage, and outputting a switching control signal for controlling a switching of the converting unit on the basis of the comparison result

2. The apparatus of claim 1, further comprising an impedance matching unit for matching an impedance of a power line of the fuel cell to an impedance of a substantial commercial power line.

3. The apparatus of claim 1, further comprising a filter for filtering the AC voltage outputted from the converting unit and thereby outputting an AC voltage of a sine wave.

4. The apparatus of claim 2, wherein the impedance matching unit comprises:
a first coil having a front end connected to an output port of the fuel cell;
a first capacitor having a front end connected to the output port of the fuel cell;
a second coil having a front end connected to a rear end of the first coil and a rear end connected to a rear end of the first capacitor; and
a second capacitor connected between the rear end of the first coil and the front end of the second coil.

5. The apparatus of claim 1, wherein the converting unit comprises:
a second PNP transistor having a collector connected to an emitter of a first PNP transistor;
a third PNP transistor having a collector connected to a collector of the first PNP transistor; and
a fourth PNP transistor having a collector connected to an emitter of the third PNP transistor and having an emitter connected to an emitter of the second PNP transistor, wherein the converting unit outputs a difference value between a voltage generated at a connection point between the first PNP transistor and the second PNP transistor and a voltage generated at a connection point between the third PNP transistor and the fourth PNP transistor.

6. The apparatus of claim 5, wherein a diode is respectively connected to the first to fourth PNP transistors in parallel.

7. The apparatus of claim 1, further comprising a storing unit for storing each RMS value corresponding to a plurality of AC voltage levels.

8. The apparatus of claim 1, wherein the controlling unit compares an AC voltage outputted from the fuel cell with an AC voltage set by a user, drops the AC voltage outputted from the fuel cell when the AC voltage outputted from the fuel cell is larger than the AC voltage set by a user, and boosts the AC voltage outputted from the fuel cell when the AC voltage outputted from the fuel cell is smaller than the AC voltage set by a user.

9. The apparatus of claim 8, wherein in a voltage dropping mode, the controlling unit converts a level of the AC voltage detected by the voltage detecting unit into an RMS value, and increases dead time of a switching control signal for simultaneously turning off the first PNP transistor, the second PNP transistor, the third PNP transistor, and the fourth PNP transistor if the converted RMS value is larger than an RMS value corresponding to the preset AC voltage.

10. The apparatus of claim 9, wherein the controlling unit decreases dead time of a switching control signal for simultaneously turning off the first PNP transistor, the second PNP transistor, the third PNP transistor, and the fourth PNP transistor if the converted RMS value is smaller than the RMS value corresponding to the preset AC voltage.

11. The apparatus of claim 8, wherein in a voltage boosting mode, the controlling unit converts a level of the AC voltage detected by the voltage detecting unit into an RMS value, and increases overlap tim The apparatus of claim 9, wherein the controlling unit decreases dead time of a switching control signal for simultaneously turning off the first PNP transistor, the second PNP transistor, the third PNP transistor, and the fourth PNP transistor if the converted RMS value is smaller than the RMS value corresponding to the preset AC voltage.

12. The apparatus of claim 11, wherein the controlling unit decreases overlap time of a switching control signal for simultaneously turning on the first PNP transistor, the second PNP transistor, the third PNP transistor, and the fourth PNP transistor if the converted RMS value is smaller than the RMS value corresponding to the preset AC voltage.

13. The apparatus of claim 3, wherein the filter comprises a capacitor for discharging a charged voltage when the converting unit performs a voltage dropping operation.

14. A power converting apparatus for a fuel cell that comprises a stack unit having an anode and a cathode and generating electric power by electrochemically reacting hydrogen and air, the apparatus comprising:
an impedance matching unit for matching an impedance of a power line of the fuel cell to an impedance of a substantial commercial power line;
a converting unit for converting a DC voltage inputted from the impedance matching unit into a boosted or dropped AC voltage by being switched by a switching control signal;
a filter for filtering an AC voltage outputted from the converting unit and thereby outputting an AC voltage of a sine wave;
a power detecting unit for detecting a level of an AC voltage outputted from the filter; and
a controlling unit for comparing the detected AC voltage level with a preset AC voltage level, and controlling a conversion of the DC voltage outputted from the fuel cell into an AC voltage on the basis of the comparison result.

15. A power converting method for a fuel cell, comprising:
detecting a level of an AC voltage outputted from a fuel cell; and
comparing the detected AC voltage level with a preset AC voltage level, and controlling a conversion of the AC voltage outputted from the fuel cell.

16. The method of claim 15, wherein the step of controlling a conversion comprises:
comparing the AC voltage outputted from the fuel cell with an AC voltage preset by a user, and dropping the AC voltage outputted from the fuel cell when the AC voltage outputted from the fuel cell is larger than the preset AC voltage; and
boosting the AC voltage outputted from the fuel cell when the AC voltage outputted from the fuel cell is smaller than the preset AC voltage.

17. The method of claim 16, wherein the step of dropping the AC voltage comprises:
converting the detected AC voltage into an RMS value; and
increasing dead time of a switching control signal applied to a converting unit when the converted RMS value is larger than an RAM value corresponding to the preset AC voltage.

18. The method of claim 17, wherein if the converted RMS value is smaller than the RAM value corresponding to the preset AC voltage, dead time of a switching control signal applied to the converting unit is decreased.

19. The method of claim 16, wherein the step of boosting the AC voltage comprises:
converting the detected AC voltage into an RMS value; and
increasing overlap time of a switching control signal applied to the converting unit when the converted RMS value is larger than an RAM value corresponding to the preset AC voltage.

20. The method of claim 19, wherein if the converted RMS value is smaller than the RAM value corresponding to the preset AC voltage, overlap time of a switching control signal applied to the converting unit is decreased.
